# EUROPEAN PATENT APPLICATION

(11) **EP 3 079 081 A1**
(43) Date of publication of application: **12.10.2016**
(21) Application number: 15305528.0
(22) Date of filing: 10.04.2015
(51) Int. Cl.: G06F 17/30

(54) **Method and device for coding the coordinates of a set of points**

(71) Applicant: Thomson Licensing, 92130 Issy-les-Moulineaux (FR)
(72) Inventor: Vigouroux, Jean-Ronan, 35576 CESSON SEVIGNE CEDEX (FR); Chevallier, Louis, 35576 CESSON SEVIGNE CEDEX (FR); Lefebvre, Frédéric, 35576 CESSON SEVIGNE CEDEX (FR)
(74) Representative: Huchet, Anne

(57) **Abstract**

The invention relates to a method for coding the coordinates of a set of points comprises ordering the points in at least one ordered set, and coding the position of the next point with respect to the previous one of the at least one ordered set. Advantageously the order of the points in the at least one ordered set is obtained by applying at least one minimum spanning tree on the set of points. To enable a precise reconstruction, the reconstructed points are computed in the coder and the next point is coded with respect to the previous reconstructed point.

## Description

### 1. TECHNICAL FIELD

In the following, a method for coding the coordinates of a set of points in an image is disclosed. Such method is useful in content based image retrieval systems where queries are generated for finding images similar to another image in large databases. Such queries generally require a large number of feature points. When a query is transmitted over a network, a compact representation of the feature points is desired. Corresponding device is also disclosed.

### 2. BACKGROUND ART

This section is intended to introduce the reader to various aspects of art, which may be related to various aspects of the present invention that are described and/or claimed below. This discussion is believed to be helpful in providing the reader with background information to facilitate a better understanding of the various aspects of the present invention. Accordingly, it should be understood that these statements are to be read in this light, and not as admissions of prior art.

Methods are known for coding the coordinates of a set of feature points in the context of content based image retrieval applications. For example, Tsai et al. proposed a method based on Location Histogram Coding (LHC) in "Location coding for mobile image retrieval", in the Proceedings of the 5th International ICST Mobile Multimedia Communications Conference in 2009. A grid is overlaid on the original image, and the number of feature points in each grid cell is computed. Two tables are generated, one indicating which grid cells are non-empty, the other indicating, for each non-empty cell the number of feature points it contains. Both tables are then encoded using an arithmetic coder. In such prior art methods, there is a tradeoff between the size of the query and the precision of the coordinates. When a certain level of precision in the feature point coordinates is required, the size of the query may be very large and prohibitive for certain applications, such as for example the image retrieval applications running on smartphones and querying large databases over a network. Moreover, very large queries generally comprise a huge number of feature points, with a high level of spatial correlation (feature points tend to accumulate in specific regions), which are not leveraged by prior art methods. Consequently, there is a need for new coding methods providing a better tradeoff between query size and precision of the feature point coordinates.

### 3. SUMMARY

A method for coding the coordinates of a set of points comprises ordering the points in at least one ordered set, and coding the position of the next point with respect to the previous one of the at least one ordered set. Advantageously the order of the points in the at least one ordered set is obtained by applying at least one minimum spanning tree on the set of points. To enable a precise reconstruction, the reconstructed points are computed in the coder and the next point is coded with respect to the previous reconstructed point.

To this end a method for coding the coordinates of a set of points in an image is disclosed. The method comprises obtaining at least one ordered set of points comprising an initial point and other points, and coding the relative coordinates of each of the other points with respect to the coordinates of a previous point in the at least one ordered set of points.

According to a preferred embodiment, the relative coordinates of each of the other points with respect to a previous point in the at least one ordered set are the difference between the coordinates of each of the other points and the coordinates of the previous point.

According to a particularly advantageous variant the points are placed on an axis and the at least one ordered set of points is obtained by ordering the points by an increasing value of their linear coordinate on the axis.

According to another particularly advantageous variant, at least one ordered set is obtained by applying at least one ordered tree structure on the set of points.

According to another particularly advantageous variant, at least one ordered set is a minimum spanning tree.

According to another particularly advantageous variant, at least one ordered set is a minimum Steiner tree.

According to another particularly advantageous variant, coding the relative coordinates of each of the other points further comprises applying an entropic coding.

According to another particularly advantageous variant, coding the relative coordinates of an other point with respect to a previous point in the at least one ordered set of points further comprises reconstructing the coordinates of a previous point by decoding its previously coded coordinates and coding the relative coordinates of the other point with respect to the reconstructed previous point coordinates

According to another particularly advantageous variant, obtaining at least one ordered set further comprises obtaining at least one first level subset of points and a plurality of second level subsets of points, wherein at least one point of each of the plurality of second level subsets of points belongs to at least one first level subset of points, and wherein an ordered set is obtained for each of the first and second level subsets of points.

In a second aspect, a method for decoding the coordinates of a set of points in an image is also disclosed, wherein the coded coordinates of each of the points are obtained by coding the relative coordinates with respect to the coordinates of a previous point in an ordered set of points obtained for the set of points.

In a third aspect, a coded signal is also disclosed. The coded signal is a set of values coding the coordinates of a set of points in an image, comprising:
- at least one value for coding the coordinates of at least one point, called at least one initial point;
- a plurality of values coding the relative coordinates of each of the other points, different from the at least one initial point, with respect to the coordinates of their previous point, wherein said points are ordered in at least one ordered set of points, according to the point coordinates and starting from at least one initial point.

In a fourth aspect, a device for coding the coordinates of a set of points in an image is also disclosed. The device comprises a processor configured to:
- Obtain at least one ordered set of points comprising an initial point and other points;
- Code the relative coordinates of each of the other points with respect to the coordinates of a previous point in at least one ordered set of points.

According to a preferred embodiment, the relative coordinates of each of the other points with respect to a previous point in the at least one ordered set are the difference between the coordinates of each of the other points and the coordinates of the previous point.

According to a particularly advantageous variant the points are placed on an axis and the at least one ordered set of points is obtained by ordering the points by an increasing value of their linear coordinate on the axis.

According to another particularly advantageous variant, the device further comprises a processor configured to obtained at least one ordered set by applying at least one ordered tree structure on the set of points.

According to another particularly advantageous variant, at least one ordered set is a minimum spanning tree.

According to another particularly advantageous variant, at least one ordered set is a minimum Steiner tree.

According to another particularly advantageous variant, the device further comprises a coder configured to code the relative coordinates of each of the other points by applying an entropic coding.

According to another particularly advantageous variant, the device further comprises a coder configured to code the relative coordinates of an other point with respect to a previous point in the at least one ordered set of points by reconstructing the coordinates of a previous point by decoding its previously coded coordinates and by coding the relative coordinates of the other point with respect to the reconstructed previous point coordinates

According to another particularly advantageous variant, the device further comprises a processor configured to obtain at least one first level subset of points and a plurality of second level subsets of points, wherein at least one point of each of the plurality of second level subsets of points belongs to at least one first level subset of points, and wherein an ordered set is obtained for each of the first and second level subsets of points.

In a fifth aspect, a device for decoding the coordinates of a set of points is also disclosed. The device comprises a decoder configured to decode the coded coordinates of a set of points in an image, wherein the coded coordinates of each of said points are obtained by coding the relative coordinates with respect to the coordinates of a previous point in an ordered set of points obtained for the set of points.

In a sixth aspect, a computer program for coding the coordinates of a set of points in an image is also disclosed. The computer program comprises program code instructions executable by a processor for:
- Obtaining at least one ordered set of points comprising an initial point and other points;
- Coding the relative coordinates of each of the other points with respect to the coordinates of a previous point in at least one ordered set of points.

In a seventh aspect, a computer program product for coding the coordinates of a set of points in an image is also disclosed. The computer program is stored on a non-transitory computer readable medium, and comprises program code instructions executable by a processor for:
- Obtaining at least one ordered set of points comprising an initial point and other points;
- Coding the relative coordinates of each of the other points with respect to the coordinates of a previous point in at least one ordered set of points.

In a eighth aspect, a computer program for decoding the coordinates of a set of points in an image is also disclosed. The computer program comprises program code instructions executable by a processor for decoding the coded coordinates of a set of points in an image, wherein the coded coordinates of each of said points are obtained by coding the relative coordinates with respect to the coordinates of a previous point in an ordered set of points obtained for the set of points

In a ninth aspect, a computer program product for decoding the coordinates of a set of points in an image is also disclosed. The computer program is stored on a non-transitory computer readable medium, and comprises program code instructions executable by a processor for decoding the coded coordinates of a set of points in an image, wherein the coded coordinates of each of said points are obtained by coding the relative coordinates with respect to the coordinates of a previous point in an ordered set of points obtained for the set of points.

While not explicitly described, the present embodiments may be employed in any combination or sub-combination. For example, the disclosed method, device, or computer program are not limited to the described characteristics of the ordered trees.

Besides, any characteristic or variant described for the coding and decoding methods is compatible with a device intended to process the disclosed method, with a computer-readable storage medium storing program instructions, and with a computer program product.

### 4. BRIEF DESCRIPTION OF THE DRAWINGS

In the drawings, an embodiment of the present invention is illustrated. It shows:
- **Figure 1** depicts a processing device for coding the coordinates of a set of points in an image according to a specific and non-limitative embodiment of the invention;
- **Figure 2** represents an exemplary architecture of the processing device of figure 1 according to a specific and non-limitative embodiment of the invention;
- **Figure 3** represents a flow chart of a method for coding the coordinates of a set of points in an image according to a specific and non-limitative embodiment of the invention;
- **Figure 4** represents an example of a set of points illustrating a method for coding the coordinates of a set of points in an image according to a specific and non-limitative embodiment of the invention.

### 5. DESCRIPTION OF EMBODIMENTS

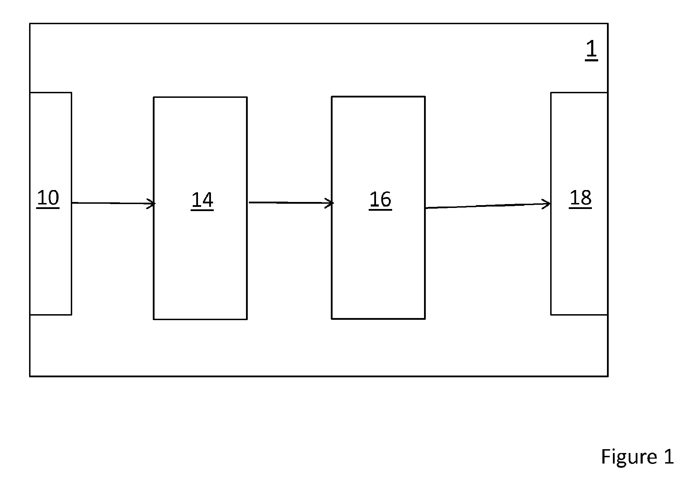

**Figure 1** depicts a processing device 1 for coding the coordinates of a set of points in an image where at least one ordered set of points is obtained, where an ordered set of points comprises an initial point and other points. Relative coordinates of each of other points are coded with respect to the coordinates of the previous point in the ordered set of points.

According to a specific and non-limitative embodiment of the invention, the processing device 1 comprises an input 10 configured to receive a set of point coordinates to code. The set of point coordinates are obtained from a source. According to different embodiments of the invention, the source belongs to a set comprising:
- a local memory, e.g. a video memory, a RAM, a flash memory, a hard disk, an SD card;
- a storage interface, e.g. an interface with a mass storage, a ROM, an optical disc or a magnetic support;
- a communication interface, e.g. a wireline interface (for example a bus interface, a wide area network interface, a local area network interface) or a wireless interface (such as a IEEE 802.11 interface Bluetooth interface, cellular mobile phone interface).

The input 10 is linked to a processing module 14 configured to obtain at least one ordered set of points comprising an initial point and other points. In case the points are placed on an axis, the points are advantageously ordered by increasing value of their linear coordinate. More generally, the processing module 14 is configured to order the points by applying at least one ordered tree on the set of points. Advantageously, the ordered tree is a minimum spanning tree, which provides the benefit of minimizing the average distance from any point to the next one in the tree. Advantageously, the ordered tree is a minimum Steiner tree, which provides the benefit of further minimizing the average distance from any point to the next one in the tree, by adding virtual points. The processing module 14 is also linked to a coder/decoder module 16 configured to code the relative coordinates of each of other points in the at least one ordered set of with respect to the coordinates of a previous point in the at least one ordered set of points. Advantageously, the relative coordinates of each of other points with respect to a previous point are the difference between the coordinates of both points. Advantageously, coding the relative coordinates further comprises applying an entropic coding. Advantageously, coding the relative coordinates of each of other points with respect to a previous point in the at least one ordered set of points further comprises reconstructing the coordinates of the previous point by decoding its previously coded coordinates and coding the relative coordinates of the point with respect to the reconstructed previous point coordinates. This provides the benefit of not cascading the errors coming from the approximation while coding the points along the ordered set. The coded coordinates of the set of points are sent by the coder/decoder module 16 to the output 18. According to different embodiments of the invention, the output belongs to a set comprising:
- a local memory, e.g. a video memory, a RAM, a flash memory, a hard disk, an SD card;
- a storage interface, e.g. an interface with a mass storage, a ROM, an optical disc or a magnetic support;
- a communication interface, e.g. a wireline interface (for example a bus interface, a wide area network interface, a local area network interface) or a wireless interface (such as a IEEE 802.11 interface Bluetooth interface, cellular mobile phone interface);

In a variant, the coded coordinates of the set of points are transmitted over a network interface, and decoded in another device for being used by an application. Similarly in another variant the coded coordinates of the set of points are received from another device over a network interface, and decoded by the coder/decoder module 16.

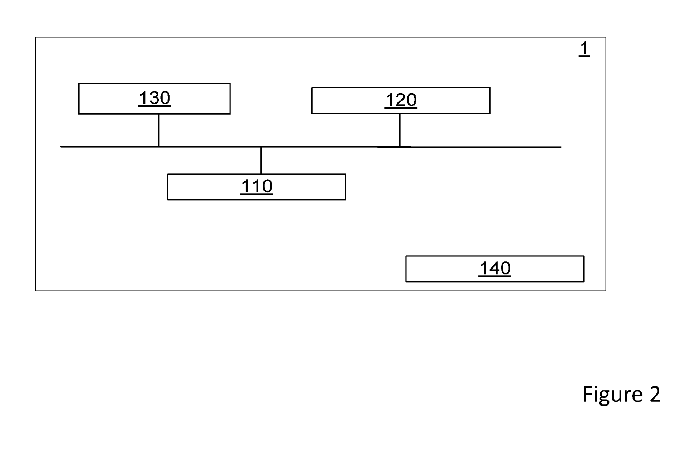

**Figure 2** represents an exemplary architecture of the processing device 1 according to a specific and non-limitative embodiment of the invention, where the processing device 1 is configured to code the coordinates of a set of points. Advantageously, the processing device 1 is configured to decode the coded coordinates of a set of points in an image wherein the coded coordinates of each of said points are obtained by coding the relative coordinates with respect to the coordinates of a previous point in an ordered set of points, obtained for the set of points. The memory stores images with the coordinates of a set of points to code and / or decode. The processing device 1 comprises one or more processor(s) 110, which is(are), for example, a CPU, a GPU and/or a DSP (English acronym of Digital Signal Processor), along with internal memory 120 (e.g. RAM, ROM, EPROM). The processing device 1 comprises one or several Input/Output interface(s) 130 adapted to send to display output information and/or to allow a user to enter commands and/or data (e.g. a keyboard, a mouse, a touchpad, a webcam, a display), and/or to send / receive data over a network interface; and a power source 140 which may be external to the processing device 1.

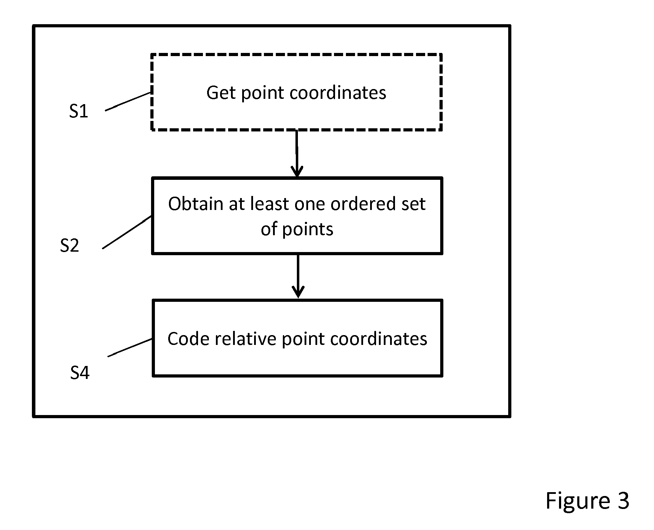

According to an exemplary and non-limitative embodiment of the invention, the processing device 1 further comprises a computer program stored in the memory 120. The computer program comprises instructions which, when executed by the processing device 1, in particular by the processor 110, make the processing device 1 carry out the processing method described with reference to figure 3. According to a variant, the computer program is stored externally to the processing device 1 on a non-transitory digital data support, e.g. on an external storage medium such as a SD Card, HDD, CD-ROM, DVD, a read-only and/or DVD drive and/or a DVD Read/Write drive, all known in the art. The processing device 1 thus comprises an interface to read the computer program. Further, the processing device 1 could access one or more Universal Serial Bus (USB)-type storage devices (e.g., "memory sticks.") through corresponding USB ports (not shown).

According to exemplary and non-limitative embodiments, the processing device 1 is a device, which belongs to a set comprising:
- a mobile device ;
- a communication device ;
- a game device ;
- a tablet (or tablet computer) ;
- a laptop ;
- a still picture camera;
- a video camera ;
- a still picture server;
- a video server (e.g. a broadcast server, a video-on-demand server or a web server).

The architecture described here for the coder is also representative of the architecture of the decoder for decoding the coordinates of the set of points in any of its variants.

**Figure 3** represents a flow chart of a method for coding the coordinates of a set of points in an image. In a first variant an image is a still picture. As such the image comprises a set of points, each point representing a pixel in the image and being located in the image by its spatial coordinates (x,y) in a two dimension space. The purpose of the method is to code the spatial coordinates of the set of points. In a second variant, the image is a spatial subpart of a still picture, for instance the top right quarter, or any other quarter, or any other kind of subdivision. In this variant the set of points is extracted from this still picture spatial subpart. In a third variant the image is a resolution subpart of a still picture. If for instance the entire image is a full HD frame (resolution 1080*1920, representing 1080 lines and 1920 columns), an image, being a subpart of the full resolution still picture is a SD resolution of it, comprising only 575 lines. In another example an image is a HD Ready resolution of the full resolution still picture, comprising only 720 lines. In another variant an image is a spatial and resolution subpart of a still picture. For certain applications it may be advantageous to extract a set of points from a still picture as a spatial or resolution subpart of it. In yet another variant an image is a 3D scene representation, and an image is no longer comprised in a two dimension space, where points are located by 2 coordinates. When an image is a 3D scene representation, points of the image are located by at least 3 coordinates (x,y,z). Any variant for an image described above as a spatial or resolution subpart of an image is also applicable for a 3D scene representation. More generally any variant described above and applied to spaces of dimensions higher than 3, where points are located in spaces with more than 3 dimensions, is compatible with this invention.

In the step S1 a set of points is extracted from an image in any of its variants. In a specific embodiment, the points are feature points : a feature point is characterized by its coordinates in an image (i.e. its spatial location) and a value, which usually is a vector comprising a plurality of values. The vector of the feature point is used to further characterize the point by carrying additional information. The vector of a feature point is also used to evaluate the similarity of it with another feature point by evaluating their vectors in addition to their spatial location. The method described hereafter focuses on the coding of the coordinates of the set of feature points. For coding the vector of a feature point in addition to the coding of its coordinates, any type of coding method is applicable and compatible with the invention. Advantageously the coding method is also applicable to code the coordinates of a set of points that do not have any vector or value associated to them. The terms feature points or points are used interchangeable in the rest of the description.

In the step S2 at least one ordered set of points is obtained from the set of points, comprising an initial point and other points. An ordered set is obtained by ordering the points according to their coordinates. An ordered set is characterized by having a single root, called the initial point, and other points that can be parsed in a well-defined and non-ambiguous order.

In a first embodiment, the points are located on an axis and an ordered set is obtained. In this embodiment a value for a linear coordinate is obtained for each of the points, and the points are ordered by for instance an increasing value of their linear coordinate along the axis. Alternatively, the ordered set is obtained by a decreasing value of their linear coordinate along the axis. The initial point is consequently the point with the smallest or highest linear coordinate value.

In a second embodiment, the points are not aligned and cannot be located on an axis. In this second embodiment a well-defined and non-ambiguous ordered set is obtained. In a first variant, the ordered set is obtained by applying a simple sweeping that enumerates the points in the vertical or horizontal order. In a second variant, the ordered set is obtained by applying an ordered tree on the set of points, where each point of the set of points is included in the ordered tree. More precisely, the ordered tree is a rooted tree, where one particular point is designated to be the root of the tree. For instance the root is one point selected at random. Advantageously, the root of the ordered tree is one of the points located most closely to the center of gravity of the tree. The root of the ordered tree is the initial point, and the other points are ordered, starting from the initial point and following a well-defined and non-ambiguous order specified by the ordered tree. Consequently for any point in the ordered set, except for the initial point, a previous point is unambiguously determined. Advantageously, for each other point, its previous point is its parent node in the ordered tree. In another variant the ordered set is obtained by applying a minimum spanning tree on the set of points. The initial point is the root that has been designated by the minimum spanning tree algorithm. A spanning tree is a set of edges connecting a set of points as a connected graph with no cycle. It is known that a spanning tree on N points has N-1 edges. In a spanning tree the weight of the edge between each pair of points is determined as the distance between those two points. Any type of distance (L₁, L₂, L₃, Lₙ) may be used to determine the weight of an edge. A minimum spanning tree is one that has a minimum sum of weights among the possible spanning trees. Advantageously the minimum spanning tree for obtaining the ordered set of points is an Euclidean minimum spanning tree, meaning that the distance for determining the weight of an edge between two points is the Euclidean distance between those points.

For instance an Euclidean ordered minimum spanning tree is computed on a set of N points by an algorithm which returns a root and a connection array which for each node n (0≤n≤N) gives the list of successor nodes in the minimum spanning tree. Advantageously an efficient algorithm implementation comprises :
- a first step of computing the Delaunay triangulation of the set of points by using the construction of the Voronoi diagram of the set of points, following the algorithm described by Steven Fortune in "A sweep line algorithm for Voronoi diagrams" in the Proceedings of the second annual Symposium on Computational Geometry in 1986 (pp 313-322).
- A second step of computing the minimum spanning tree on the Delaunay edges

The complexity of such an algorithm implementation is in O(NlogN).

In a third embodiment, virtual points are added in the set of points while obtaining the ordered set of points, in any of the variants described above. A virtual point has no description value or a NULL vector, but its position is determined so as to globally minimize the distance between nodes. For instance while building a minimum spanning tree, instead of selecting one point of the set of points for being the parent of a subset of points, there may be another point, called virtual point, not belonging to the set of points, but more ideally located, because being at a shorter distance of the other points of the subset. It is therefore advantageous to add virtual points to the ordered set of points when the distance between the virtual point and the other points of the subtree significantly decreases. The problem of adding virtual points to a set of points to enable the construction of shorter spanning trees is known as the Steiner tree problem and known to be NP-complete in its full extent.

In a first variant, a set of approximate virtual points are added to the Euclidean minimum spanning tree according to the method described in 1996 in the Proceedings of the 37th IEEE Symposium on Foundations of Computer Science, admitting approximations in polynomial time "Polynomial time approximation scheme for Euclidean TSP and other geometric problems". This method, thanks to the addition of the appropriate set of virtual points, allows to obtain an approximation of the minimum Steiner tree, having a shorter average distance than the minimum spanning tree obtained from the original set of points.

In a second variant virtual points are added in the set of points while obtaining the ordered set of points in order to enable the construction of a Rectilinear Steiner tree, that is one where the edges are either horizontal or vertical. Advantageously, the ordered set is obtained in the step S2 by applying a minimum Rectilinear Steiner tree on the set of points, where a minimum Rectilinear Steiner tree is one that has a minimum sum of distances among the possible Rectilinear Steiner trees. Such trees allow more efficient coding schemes as they contain only vertical or horizontal vertices.

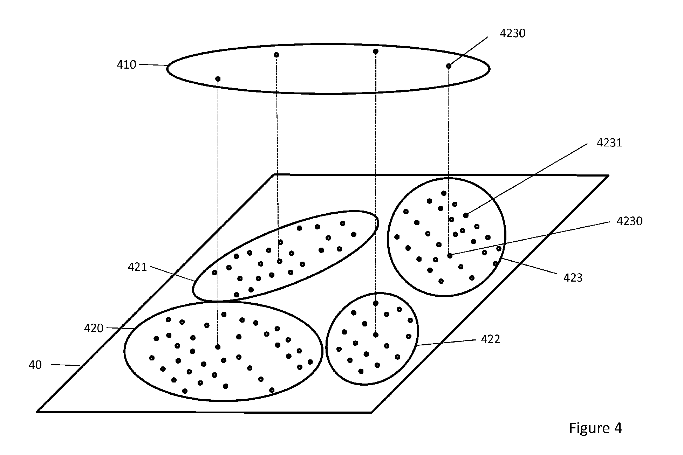

In a fourth embodiment illustrated in figure 4, several distinct ordered sets are obtained from distinct subsets 420, 421, 422, 423 of the set of points 40, in any of the variants described above. This is advantageous for example in cases where the points 4230, 4231 show a clustering with well differentiated clusters. It is also advantageous to have several ordered sets as the coding of points further described in step 4 is done per ordered set, and when accessing one particular point in the set, the coding requires to decode at least all its previous points in the ordered set. Consequently partitioning the set of points in several subsets, and obtaining ordered sets from these subsets improves the efficiency of the decoding by allowing a more efficient access to a particular point as only its previous points in its own ordered set need to be decoded. In a first variant the subsets are disjoint sets. In other words no point is allowed to belong to more than one subset. A subset with a single point is compatible with the invention. In a second variant the subsets are not disjoint. In other words, some subsets may have some points in common. If there are too many points belonging to more than one subset, there is an impact on the overall coding efficiency in terms of compression ratio. Consequently there is a tradeoff between the overall coding/compression efficiency and the decoding performance.

In case the set of points 40 accumulate in specific regions, it is advantageous to apply a clustering on the set of points for obtaining a plurality of subsets 420, 421, 422, 423 of points where a subset of points corresponds to a cluster. Any clustering technique, such as for example KMeans or DBSCAN is compatible with the coding method. Advantageously, the various subsets are further aggregated resulting in a hierarchical set comprising for instance two levels of subsets. More precisely a hierarchical set comprises at least one first level subset 410 of points, and a plurality of second level subsets 420, 421, 422, 423 of points wherein at least one point 4230, 4231 of each of the plurality of second level subsets of points belongs to at least one first level subset 410 of points.

In this embodiment, an ordered set of points is obtained for each of the subsets 410, 420, 421, 422, 423 (both first level and second level) by ordering the points according to any of the variants described above.

In a variant, the hierarchical set comprises one first level subset 410 of points, that further comprises one point 4230 per second level subset 423, where the point 4230 is representative of the subset 423 (i.e. the corresponding cluster), for instance the closest to the center of the subset of points. This enables to use a different coding scheme for the coordinates of the points at the first level (the representative points) and the coordinates of the points at the second level (the points in one cluster). This is motivated by the fact that the first level series of points and the second level series may exhibit different statistical characteristics, as for the first level series the length of the edges to be coded is typically of the order of a fraction of the image size, whereas for the second level series the length is typically in number of pixels. Hierarchical sets of more than two levels are compatible with the coding method.

In another variant the hierarchical set comprises one first level subset 410 of points, that further comprises one point 4230 per second level subset 423, where the point 4230 is the initial point of the second level ordered set obtained from the second level subset 423 of points according to any variant described above. The hierarchical set variants are advantageous as they improve the efficiency of the decoding. Indeed, decoding a single point 4231 coordinates requires to decode all its previous point coordinates from only two subsets : its own second level subset 423 and the first level subset 410. This results is decoding fewer points than in the case where a single set of point is ordered. Advantageously, if an application generally needs to access groups of points together (for instance located in a same area, or sharing a same characteristic) the subsets of points are obtained so as to match the grouping implied by the application.

In the step S4, the relative coordinates of each of the other points in an ordered set of points are coded with respect to the coordinates of a previous point in the ordered set of points. The coordinates of the initial point in the ordered set are coded by taking their absolute value. In other words the relative coordinates of the initial point are for instance coded with respect to the center of the space, having null coordinates, or using a corner of the image, for instance left-top, as origin, as it is customary to do, or any other convention. Advantageously the relative coordinates of a point A(x_{A},y_{A}) with respect to its previous point B(x_{B},y_{B}) in the ordered set are the difference between the coordinates of the point A and the coordinates of the previous point B, in other words, the relative coordinates of A with respect to B are: (x_{A}-x_{B}, y_{A}-y_{B}).

Advantageously in the case an ordered set is a Rectilinear Steiner tree in any of its variant, the relative coordinates of a point A(x_{A},y_{A}) with respect to its previous point B(x_{B},y_{B}) in the ordered set are a pair of value (m,d) where the first value is the absolute value of the difference between the changing coordinates ((x_{A}-x_{B}) in case of an horizontal edge, and (y_{A}-y_{B}) in case of a vertical edge), and the second value is an indication of the direction of the motion from the previous point B to the point A. For instance the relative coordinates of a point A(x_{A},y_{A}) with respect to its previous point B(x_{B},y_{B}) are a pair of values (m,d), where m is the absolute difference between the changing coordinate ((|x_{A}-x_{B}| or |y_{A}-y_{B}|), and d is the direction, taking 4 possible values (right_top, right_bottom, left_top, left_bottom).

Advantageously, coding the relative coordinates of each of the other points in the set of points with respect to the coordinates of a previous point, in any of its variant, is done by using an entropic coding. Entropic coding methods are lossy coding methods, known for providing good performances as they use the shortest coding words for coding the most frequent symbols. Consequently, in case relative coordinates in an ordered set of points comprise frequent patterns, the use of entropic coding is particularly advantageous. Depending on how the ordered tree is obtained on the set of points, the values of the distances between a point and its previous point in the ordered tree may show different histograms. Selecting a distance based minimum spanning tree as the ordered tree for ordering the set of points provides the benefit of having a very narrow range of very frequent values, which makes the choice of entropic coding particularly advantageous. Advantageously in any of the hierarchical set variants (where second level subsets are obtained for local clusters of points and aggregated in at least one first level subset), the coding scheme varies depending on the level in the hierarchical set. In this case the statistics of the relative coordinate length in the subsets (within the clusters) are likely to be very different from the statistics of the relative coordinate length in the first level (between the clusters). If an entropic coding is used it is advantageous to adapt the code to the statistics of the relative coordinate lengths of the corresponding level in the hierarchical set.

In the step S4, coding the relative coordinates of each of the other points with respect to a previous point in the ordered set of points further comprises reconstructing the coordinates of a previous point by decoding its previously coded coordinates and coding the relative coordinates of the other point with respect to the reconstructed previous point coordinates. Coding a point from its reconstructed previous point is advantageous in order to avoid drifting effects due to quantization. More precisely, if all the other point coordinates are coded from the exact location of their previous point, there is a risk that a location error will accumulate along the coding of the other points in the ordered set. Therefore, when coding the relative coordinates of an other point with respect to a previous point in the ordered set of point, there is an additional step of coding the coordinates of the previous point (which was already done if the other point coordinates are coded one after each), and decoding the coded coordinates of the previous point. The coordinates of the other point are then coded with respect to the previous point by using the decoded coordinates of the previous point.

**Figure 4** represents an example of a set of points illustrating the method for coding the coordinates of a set 40 of points 4230, 4231 in an image compatible with the fourth embodiment described above. The set 40 of points 4230, 4231 comprises points that accumulate in specific areas. By running for example a clustering algorithm, four subsets 420, 421, 422, 423 of points are obtained, corresponding to four clusters obtained from the clustering algorithm. In this specific embodiment, the four subsets 420, 421, 422, 423 of points are second level subsets of points in the hierarchical set. A first level subset 410 is obtained and comprises one point 4230 from each of the second level subsets 420, 421, 422, 423 of points.

## Claims

1. A method for coding the coordinates of a set of points in an image **characterized in that** the method comprises:
- Obtaining (S2) at least one ordered set of points comprising an initial point and other points;
- Coding (S4) the relative coordinates of each of said other points with respect to the coordinates of a previous point in said at least one ordered set of points.

2. The method according to claim 1, wherein said relative coordinates of each of said other points with respect to a previous point in said at least one ordered set are the difference between the coordinates of each of said other points and the coordinates of said previous point.

3. The method according to claim 1 or 2, wherein the points are placed on an axis and said at least one ordered set of points is obtained (S2) by ordering the points by an increasing value of their linear coordinate on said axis.

4. The method according to claim 1 or 2, wherein said at least one ordered set is obtained (S2) by applying at least one ordered tree on said set of points.

5. The method according to claim 4, wherein said at least one ordered tree is a minimum spanning tree.

6. The method according to claim 4, wherein said at least one ordered tree is a minimum Steiner tree.

7. The method according to any of claims 1 to 6, wherein coding (S4) the relative coordinates of each of said other points further comprises applying an entropic coding.

8. The method according to any of claims 1 to 7, wherein coding (S4) the relative coordinates of a said other point with respect to a previous point in said at least one ordered set of points further comprises reconstructing the coordinates of a previous point by decoding its previously coded coordinates and coding the relative coordinates of the other point with respect to said reconstructed previous point coordinates.

9. The method according to any of claims 1 to 8, wherein obtaining (S2) said at least one ordered set further comprises obtaining at least one first level subset of points and a plurality of second level subsets of points, wherein at least one point of each of said plurality of second level subsets of points belongs to said at least one first level subset of points, and wherein an ordered set is obtained (S2) for each of said first level and second level subsets of points.

10. A method for decoding the coded coordinates of a set of points in an image, wherein the coded coordinates of each of said points are obtained by coding the relative coordinates with respect to the coordinates of a previous point in an ordered set of points obtained for the set of points.

11. A coded signal, wherein said coded signal is a set of values coding the coordinates of a set of points in an image, comprising:
- at least one value for coding the coordinates of at least one point, called at least one initial point;
- a plurality of values coding the relative coordinates of each of the other points, different from said at least one initial point, with respect to the coordinates of their previous point, wherein said points are ordered in at least one ordered set of points, according to said point coordinates and starting from at least one initial point.

12. A device (1) for coding the coordinates of a set of points in an image said device (1) comprising a processor (110) configured to:
- Obtain at least one ordered set of points comprising an initial point and other points;
- Code the relative coordinates of each of said other points with respect to the coordinates of a previous point in said at least one ordered set of points.

13. A device (1) for decoding the coded coordinates of a set of points in an image, wherein the coded coordinates of each of said points are obtained by coding the relative coordinates with respect to the coordinates of a previous point in an ordered set of points obtained for the set of points.

14. A computer program for coding the coordinates of a set of points in an image, said computer program comprising program code instructions executable by a processor for:
- Obtaining at least one ordered set of points comprising an initial point and other points;
- Coding the relative coordinates of each of said other points with respect to the coordinates of a previous point in said at least one ordered set of points.

15. A computer program product for coding the coordinates of a set of points in an image, said computer program being stored on a non-transitory computer readable medium, and comprising program code instructions executable by a processor for:
- Obtaining at least one ordered set of points comprising an initial point and other points;
- Coding the relative coordinates of each of said other points with respect to the coordinates of a previous point in said at least one ordered set of points.
